# DEMANDE DE BREVET EUROPEEN

(11) **EP 2 190 024 A1**
(43) Date de publication de la demande: **26.05.2010**
(21) Numéro de dépôt: 08169424.2
(22) Date de dépôt: 19.11.2008
(51) Int. Cl.: H01L 31/0236, H01L 31/078

(54) **Dispositif photoélectrique a jonctions multiples et son procédé de realisation**

(71) Demandeur: Université de Neuchâtel, 2000 Neuchatel (CH)
(72) Inventeur: Domine, Didier, 2825 Courchapoix (CH); Cuony, Peter, 2000 Neuchâtel (CH); Bailat, Julien, 2855 Glovelier (CH)
(74) Mandataire: GLN

(57) **Abrégé**

La présente invention concerne un dispositif photoélectrique (1) à jonctions multiples comprenant un substrat (2) sur lequel est déposée une première couche conductrice (3), au moins deux dispositifs photoélectriques élémentaires (4, 6) de configuration p-i-n ou p-n, sur lesquels est déposée une seconde couche conductrice (7), et au moins une couche intermédiaire (5) prévue entre deux dispositifs photoélectriques élémentaires adjacents (4, 6).

Selon l'invention, la couche intermédiaire (5) présente, du côté de la lumière entrant, une face supérieure (10) et de l'autre côté, une face inférieure (11), les dites faces supérieure (10) et inférieure (11) présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ est l'angle pour lequel 90% des surfaces élémentaires de la face supérieure (10) de la couche intermédiaire (5) présentent une inclinaison inférieure ou égale à cet angle, et α_{90inf} est l'angle pour lequel 90% des surfaces élémentaires de la face inférieure (11) de la couche intermédiaire (5) présentent une inclinaison inférieure ou égale à cet angle.

## Description

### Domaine technique

La présente invention se rapporte au domaine des dispositifs photoélectriques. Elle concerne, plus particulièrement, un dispositif photoélectrique composé de cellules élémentaires de configuration p-i-n ou p-n, empilées les unes sur les autres, qui absorbent la lumière sur des gammes de longueurs d'onde différentes. De tels dispositifs sont appelés cellules à jonctions multiples. L'invention concerne également un procédé de réalisation de ce dispositif photoélectrique.

La présente invention trouve une application particulièrement intéressante pour la réalisation de cellules photovoltaïques destinées à la production d'énergie électrique, mais elle s'applique également, de manière plus générale, à toute structure dans laquelle un rayonnement lumineux est converti en un signal électrique, telle que les photodétecteurs.

### Etat de la technique

Classiquement, une cellule double jonction ou tandem en couche minces de silicium est constituée d'une cellule supérieure en silicium amorphe, qui absorbe la lumière visible (jusqu'à environ 750 nm) et d'une cellule inférieure en silicium microcristallin qui absorbe la lumière jusque dans l'infrarouge (jusqu'à 1100 nm environ). Une telle cellule est appelée cellule "Micromorph". Dans la présente description, "supérieur" signifie le côté proche de la lumière incidente, et "inférieur" signifie le côté éloigné de la lumière incidente.

Pour augmenter le courant, dans une cellule simple comme dans une cellule à jonction multiple, le contact transparent avant est rugueux afin de diffuser la lumière dans le dispositif. Une surface rugueuse est constituée d'une succession de bosses et de creux formés de surfaces élémentaires plus ou moins inclinées. La morphologie de la surface du substrat joue un rôle primordial dans les performances optiques (courant de court-circuit (Jcc)) et électriques (tension de circuit ouvert (Vco) et facteur de forme (FF)), i.e. l'efficacité, de la cellule.

En ce qui concerne les cellules microcristallines, une telle cellule a de meilleures caractéristiques électriques (meilleurs facteurs de forme (FF) et tension de circuit ouvert (Vco)) si elle est déposée sur un substrat sans ou comprenant peu de surfaces élémentaires fortement inclinées. Cependant, les surfaces élémentaires fortement inclinées aux interfaces avec un changement d'indice de réfraction favorisent la diffusion de la lumière dans la cellule. Ainsi, les caractéristiques optiques de la cellule (courant de court-circuit (Jcc)) sont améliorées. Dès lors, la morphologie optimale est un compromis entre les caractéristiques électriques et optiques de la cellule solaire.

En ce qui concerne les cellules amorphes, les caractéristiques électriques de la cellule amorphe souffrent beaucoup moins d'une morphologie de substrat présentant des surfaces élémentaires fortement inclinées. Cependant, elle souffre d'une dégradation de l'efficacité lors de son exposition à la lumière. Le moyen de limiter la dégradation est de diminuer l'épaisseur de la cellule. Afin de diminuer l'épaisseur de la cellule et de conserver de bonnes efficacités, on utilise des substrats avec des surfaces élémentaires fortement inclinées qui augmentent la diffusion de la lumière dans la cellule.

Dans une cellule tandem ou multi-jonction, le problème consiste à augmenter le courant dans les cellules en utilisant des surfaces rugueuses qui diffusent la lumière dans la cellule tout en conservant des bonnes caractéristiques électriques de la cellule. Cependant, les morphologies optimales pour les cellules supérieures et inférieures sont différentes. En effet, la cellule supérieure nécessite une morphologie de substrat présentant des surfaces élémentaires fortement inclinées afin d'augmenter son courant, de réduire son épaisseur et ainsi de limiter sa dégradation. Néanmoins, sur ce type de morphologie, la cellule microcristalline inférieure souffre d'une morphologie inadaptée, ce qui se manifeste dans la cellule tandem par les mêmes symptômes que dans une cellule simple : une chute du facteur de forme FF et de la tension de circuit ouvert Vco.

Pour pallier ce problème, il a été proposé de placer un miroir intermédiaire (50-150 nm) entre la cellule supérieure et la cellule inférieure, permettant d'augmenter le courant de la cellule supérieure. Un miroir intermédiaire est une couche intercalée entre deux cellules élémentaires avec un indice de réfraction (n) inférieur aux indices de réfraction des cellules élémentaires. Pour une cellule "Micromorph", un tel miroir intermédiaire avec un indice de réfraction (n) typiquement entre 1.3 à 2.5 est intercalé entre la cellule supérieure et la cellule inférieure. Ceci permet d'augmenter le courant de la cellule supérieure sans avoir à augmenter son épaisseur, ce qui minimise l'effet de la dégradation de la cellule supérieure sous illumination et sans avoir à augmenter la rugosité du substrat, ce qui permet de garder des bonnes caractéristiques électriques de la cellule inférieure.

Cependant, la morphologie de surface de la cellule supérieure sur laquelle on dépose le miroir intermédiaire est très similaire à la surface du miroir intermédiaire déposé. En d'autres termes, le dépôt du miroir intermédiaire reproduit la morphologie de surface de la cellule supérieure et ne permet pas de changer la morphologie pour produire une morphologie adaptée à la croissance de la cellule inférieure.

Les brevet US 6,825,408 et US 6,459,034 décrivent l'utilisation, entre la cellule supérieure et la cellule inférieure, d'une couche intermédiaire présentant des surfaces irrégulières de hauteurs différentes, la surface du côté de la cellule inférieure ayant une différence de hauteur moyenne supérieure à celle de la surface du côté de la cellule supérieure.

Toutefois, ces critères de hauteur ne permettent pas non plus d'obtenir les morphologies de surface optimales pour les deux cellules. En effet, cela permet certes d'augmenter le pourcentage de lumière entrant dans le dispositif, mais le gain en efficacité n'est pas encore suffisant. De plus, le brevet US 6,825,408 concerne uniquement des cellules de type n-i-p, pour lesquelles les morphologies de surface présentent une configuration inverse à celle recherchée pour les cellules de type p-i-n. Enfin, le brevet US 6,459,034 décrit, dans son exemple 5, un dispositif photoélectrique comprenant deux cellules de type p-i-n séparées par une couche intermédiaire. Toutefois, la cellule supérieure est déposée sur un substrat présentant peu de surfaces élémentaires inclinées, et la morphologie de surface de la couche intermédiaire du côté de la cellule inférieure présente plus de surfaces élémentaires fortement inclinées que celle du côté de la cellule supérieure. Ceci est contraire au problème à résoudre de la présente invention, qui est d'optimiser les morphologies de surface dans un dispositif photoélectrique comprenant une cellule supérieure qui doit être déposée sur un substrat présentant des surfaces élémentaires fortement inclinées et une cellule inférieure qui doit croitre sur une morphologie de surface avec peu de surfaces élémentaires fortement inclinées.

Un but de la présente invention est donc de pallier ces inconvénients, en proposant un dispositif photoélectrique plus performant, présentant des morphologies de surface optimales pour les deux cellules.

### Divulgation de l'invention

A cet effet, et conformément à la présente invention, il est proposé un dispositif photoélectrique à jonctions multiples comprenant un substrat sur lequel est déposée une première couche conductrice, au moins deux dispositifs photoélectriques élémentaires de configuration p-i-n ou p-n, sur lesquels est déposée une seconde couche conductrice, et au moins une couche intermédiaire prévue entre deux dispositifs photoélectriques élémentaires adjacents, ladite couche intermédiaire présentant, du côté de la lumière entrant, une face supérieure et de l'autre côté, une face inférieure, les dites faces supérieure et inférieure présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ est l'angle pour lequel 90% des surfaces élémentaires de la face supérieure de la couche intermédiaire présentent une inclinaison inférieure ou égale à cet angle, et α_{90inf} est l'angle pour lequel 90% des surfaces élémentaires de la face inférieure de la couche intermédiaire présentent une inclinaison inférieure ou égale à cet angle.

De telles morphologies de surface permettent de concilier de manière optimale les morphologies requises par chacune des faces de la couche intermédiaire, et d'obtenir ainsi un dispositif plus performant.

La présente invention concerne également un procédé de réalisation d'un dispositif photoélectrique à jonctions multiples comprenant un substrat sur lequel est déposée une première couche conductrice, au moins deux dispositifs photoélectriques élémentaires de configuration p-i-n ou p-n, sur lesquels est déposée une seconde couche conductrice. Selon l'invention, le procédé comprend une étape de dépôt, sur au moins l'un desdits dispositifs photoélectriques élémentaires, d'une couche intermédiaire présentant, du côté de la lumière entrant, une face supérieure et de l'autre côté, une face inférieure, les dites faces supérieure et inférieure présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ et α_{90inf} sont définis ci-dessus.

### Brève description des dessins

D'autres caractéristiques de la présente invention apparaîtront plus clairement à la lecture de la description qui va suivre, faite en référence aux dessins annexés, dans lesquels:
- la figure 1 représente un schéma d'une cellule tandem selon l'invention,
- la figure 2 représente un schéma illustrant le calcul de l'angle d'inclinaison de la surface au point A d'une image obtenu par microscope à force atomique (AFM), et
- la figure 3 représente l'intégrale de la distribution angulaire des faces supérieure et inférieure de la couche intermédiaire dans un dispositif selon l'invention.

### Mode(s) de réalisation de l'invention

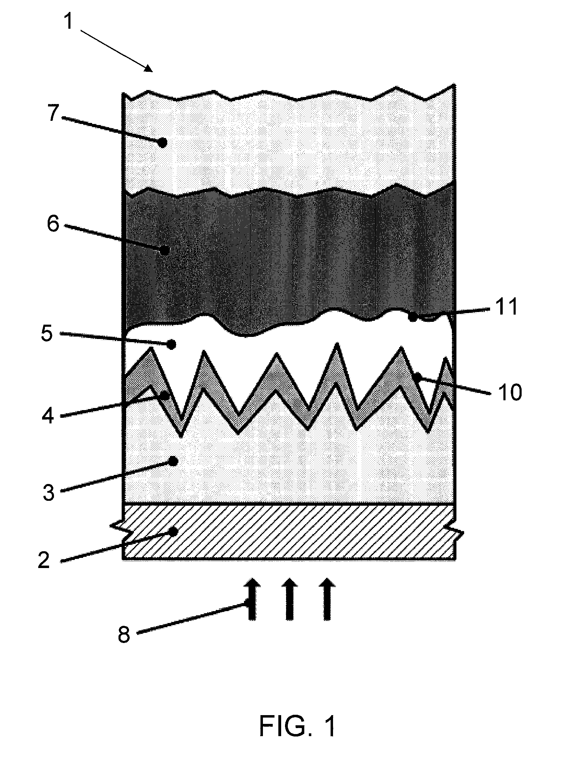

En référence à la figure 1, il est représenté un dispositif photoélectrique ou une cellule "Micromorph" 1 comprenant, empilés les uns sur les autres, un substrat 2, une première couche conductrice 3 transparente, constituant une première électrode, un premier dispositif photoélectrique élémentaire 4, appelé cellule supérieure, une couche intermédiaire 5, un second dispositif photoélectrique élémentaire 6, appelé cellule inférieure, et une seconde couche conductrice 7, constituant une seconde électrode. Le dispositif 1 est exposé à la lumière orientée selon les flèches 8.

La couche intermédiaire 5 présente, du côté de la lumière entrant, une face supérieure 10 et de l'autre côté, une face inférieure 11.

Selon l'invention, lesdites faces supérieure 10 et inférieure 11 présentent respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ est l'angle pour lequel 90% des surfaces élémentaires de la face supérieure de la couche intermédiaire présentent une inclinaison inférieure ou égale à cet angle, et α_{90inf} est l'angle pour lequel 90% des surfaces élémentaires de la face inférieure de la couche intermédiaire présentent une inclinaison inférieure ou égale à cet angle.

Par exemple, la différence entre α₉₀ₛᵤₚ et α_{90inf} peut être comprise entre 3° et 60°, préférentiellement comprise entre 6° et 25°, et plus préférentiellement encore comprise entre 10° et 15.

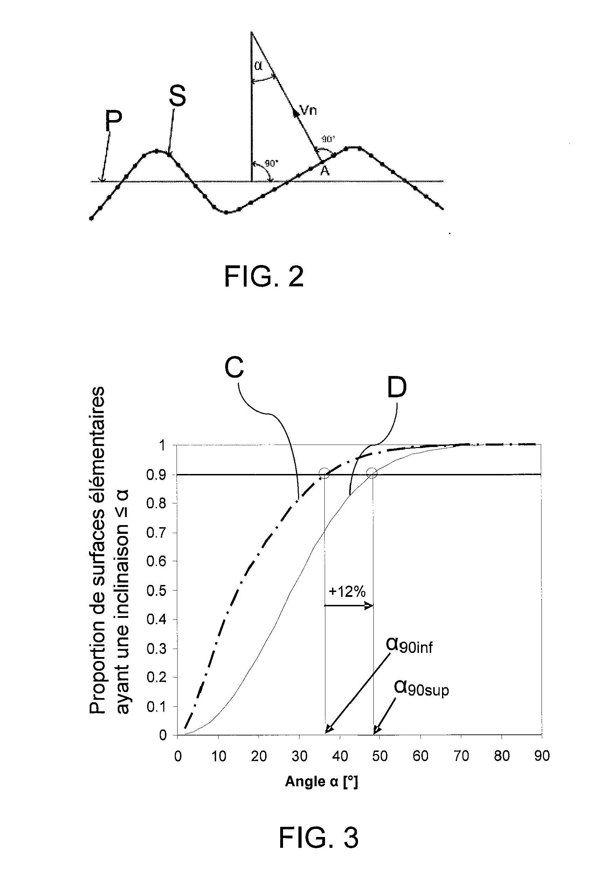

En référence à la figure 2, la morphologie de la surface est décrite ici par les inclinaisons des surfaces élémentaires composant la surface rugueuse de l'échantillon, aussi appelée distribution angulaire de la surface. Pour ce faire, on réalise une mesure AFM sur une surface de 5 µm * 5 µm correspondant à une matrice de 256 * 256 points équidistants (axes x et y dans le système de coordonnés traditionnel) qui représente la topologie (axe z) de la surface de l'échantillon. Afin d'éliminer une éventuelle inclinaison ou courbure du substrat, on soustrait de cette image le polynôme d'ordre 2 qui minimise la somme des écarts au carré entre celui-ci et la surface. On obtient ainsi une bonne représentation de la morphologie de la surface S qui est typiquement constituée de structures de tailles entre 50 et 2000 nm. Le plan z=0 est défini comme étant le plan horizontal P.

Pour obtenir la distribution angulaire des surfaces, on calcule, pour chaque point A de l'image AFM, l'angle entre le vecteur normal au plan horizontal P et le vecteur Vn normal à la surface S. Pour ce faire, la surface élémentaire considérée pour calculer la normale au point A est définie par le point A et deux vecteurs Vx et Vy. Vx est le vecteur qui relie les deux points (proches voisins dans la matrice AFM) avant et après le point A dans la direction x et Vy est le vecteur qui relie les deux points (proches voisins dans la matrice AFM) avant et après le point A dans la direction y. Le vecteur normal Vn à la surface élémentaire considérée est déterminé par le produit vectoriel de Vx et Vy. L'angle d'inclinaison α de la surface élémentaire est défini comme étant l'angle entre le vecteur normal Vn de la surface élémentaire considérée et le vecteur normal au plan horizontal P.

On peut construire une nouvelle matrice de points représentant l'inclinaison de chaque surface élémentaire en chaque point de la matrice AFM. A partir de la matrice qui indique l'inclinaison à chaque point de la surface, on peut faire un histogramme des angles de 0 à 90° (distribution angulaire) qui donne la proportion de la surface qui a une inclinaison compris dans un certain intervalle d'angles (typiquement 2 degrés). En intégrant celui-ci on obtient l'intégrale de la distribution angulaire (cf. Figure 3). Les angles sont représentés en abscisse. En ordonnée est représentée la proportion des surfaces élémentaires présentant une inclinaison égale ou inférieure à un angle donné. Une surface horizontale et plate est définie comme n'ayant que des surfaces élémentaires présentant une inclinaison selon un angle égal à 0°, et donc l'intégrale de la distribution angulaire est égale à 1 entre 0° et 90°. Par contre une surface extrêmement rugueuse, avec des surfaces élémentaires fortement inclinées, montre une distribution angulaire avec une grande proportion de surfaces élémentaires présentant des inclinaisons élevées et donc l'intégrale de la distribution angulaire est proche de 0 pour les petits angles (ex : 0°-15°) et est proche de 1 seulement pour les grands angles (ex : 30°-70°).

Dans la présente invention, pour caractériser la morphologie d'une surface, la valeur α considérée est l'angle α₉₀ pour lequel 90% de la surface étudiée montre des facettes présentant une inclinaison inférieure ou égale à cet angle.

De préférence, l'angle α₉₀ₛᵤₚ est compris entre 40° et 80°.

De préférence, l'angle α_{90inf} est compris entre 0° et 40°.

Le substrat 2 peut être réalisé dans un matériau choisi parmi le groupe comprenant le verre et les matières plastiques (par exemple PEN, PET, polyimide).

La première couche conductrice 3 est réalisée en oxyde conducteur transparent (par exemple ZnO, ITO, SnO₂) (cf. S. Fay, J. Steinhauser, N. Oliveira, E. Vallat-Sauvain, C. Ballif, "Opto-electronic properties of rough LP-CVD ZnO:B for use as TCO in thin-film silicon solar cells", Thin Solid Films, 515 (24), p.8558-8561, 2007).

La deuxième couche conductrice 7 est réalisée en oxyde conducteur transparent (par exemple ZnO, ITO, InO, SnO₂, etc.), en métal (Ag, AI), ou la combinaison d'un oxyde transparent et d'un métal (cf. J. Meier, U. Kroll, J. Spitznagel, S. Benagli, T. Roschek, G. Pfanner, C. Ellert, G. Androutsopoulos, A. Huegli, G. Buechel, A. Buechel, M. Nagel, L. Feitknecht, C. Bucher, « Progress in up-scaling of thin film silicon solar cells by large-area PECVD KAI systems », Proc. of the 31th IEEE Photovoltaic Specialist Conference, Lake Buena Vista, FL, USA, , pp. 1464-1467, January, 2005).

Les couches conductrices 3 et 7 sont déposées par les procédés connus de l'homme du métier, tels qu'évaporation, pulvérisation cathodique, dépôt chimique. De préférence, on utilise pour la première couche conductrice 3 le procédé de dépôt chimique (exemples : LP-CVD ZnO, AP-CVD Sn02) (cf. S. Fay, J. Steinhauser, N. Oliveira, E. Vallat-Sauvain, C. Ballif, "Opto-electronic properties of rough LP-CVD ZnO:B for use as TCO in thin-film silicon solar cells", Thin Solid Films, 515 (24), p.8558-8561, 2007), permettant d'obtenir une couche conductrice présentant une morphologie de surface optimale pour la cellule élémentaire supérieure 4.

Les dispositifs photoélectriques élémentaire 4 et 6 peuvent présenter la configuration p-i-n ou p-n. Cela signifie que la première couche déposée pour réaliser la cellule élémentaire est la couche p, puis, éventuellement i, et n. Il est bien évident que toutes les combinaisons sont possibles. Notamment lorsque le dispositif comprend deux cellules élémentaires, les quatre combinaisons p-i-n/p-i-n, p-n/p-i-n, p-n/p-n et p-i-n/p-n sont possibles. La combinaison p-i-n/p-i-n est préférée.

Avantageusement, le dispositif photoélectrique élémentaire 4 ou "cellule supérieure", situé du coté du substrat 2 par rapport à la couche intermédiaire 5, est réalisé dans un matériau semiconducteur caractérisé par une bande d'énergie interdite E_{gsup} et l'autre dispositif photoélectrique élémentaire 6 ou "cellule inférieure", situé de l'autre coté par rapport à la couche intermédiaire 5, est réalisé dans un matériau semiconducteur caractérisé par une bande d'énergie interdite E_{ginf}. Préférablement, E_{gsup} est supérieur à E_{ginf} afin d'absorber de manière complémentaire le spectre de la lumière solaire.

Le dispositif photoélectrique élémentaire 4, ou cellule supérieure est un semiconducteur permettant une application photovoltaïque, de préférence à base de silicium. De préférence, il est à base de silicium amorphe ou d'un composé de silicium (par exemple SIC, SiO, SiGe etc.). Il présente une épaisseur comprise entre 20 et 800 nm, préférentiellement comprise entre 100 nm et 250 nm.

Le dispositif photoélectrique élémentaire 6, ou cellule inférieure, est un semiconducteur permettant une application photovoltaïque, de préférence à base de silicium. De préférence, il est à base de silicium cristallin, microcristallin ou silicium germanium ou d'un composé de silicium permettant de diminuer le gap par rapport au silicium amorphe.

De préférence, le dispositif photoélectrique élémentaire 4, ou cellule supérieure, est à base de silicium amorphe et l'autre dispositif photoélectrique élémentaire 6, ou cellule inférieure, est à base de silicium microcristallin.

Les cellules élémentaires 4 et 6 sont déposées par les procédés connus de l'homme du métier. De préférence, on utilise un procédé de dépôt chimique en phase vapeur assisté par décharge plasma (PECVD) (cf. D. Fischer, S. Dubail, J. A. A. Selvan, N. P. Vaucher, R. Platz, C. Hof, U. Kroll, J. Meier, P. Torres, H. Keppner, N. Wyrsch, M. Goetz, A. Shah, and K.-D. Ufert, in 25 IEEE PVSC, Washington D. C., 1996, p. 1053).

Après le dépôt de la cellule élémentaire supérieure 4, on dépose une couche intermédiaire 5 qui permet de rétablir une morphologie adaptée à la cellule élémentaire inférieure 6.

La couche intermédiaire 5 est constituée d'une couche d'un matériau choisi parmi le groupe comprenant l'oxyde de zinc, des oxydes de silicium dopés, des oxydes de silicium poreux dopés, l'oxyde d'étain, l'oxyde d'indium, le carbure de silicium dopé, le silicium amorphe dopé, le silicium microcristallin dopé, ainsi que leurs combinaisons. De préférence, on utilise de l'oxyde de silicium dopé, dont l'indice de réfraction est inférieur à celui du silicium, et est compris entre 1,3 et 2,5.

De préférence, la couche intermédiaire 5 présente une épaisseur comprise entre 10 nm et 500 nm, plus préférentiellement entre 50 nm et 150 nm.

Selon une variante de l'invention, la morphologie de surface de la face inférieure 11 de la couche intermédiaire 5, telle que définie ci-dessus, peut être obtenue par la nature même de son procédé de fabrication. Pour cela, lors de l'étape de dépôt de la couche intermédiaire 5, on utilise un procédé de dépôt de la couche intermédiaire 5 permettant d'obtenir une surface aplanie correspondant à la morphologie de surface de la face inférieure 11 requise. Ce procédé utilise l'une des techniques choisies parmi le groupe comprenant la pulvérisation cathodique (cf. Thornton, J. Vac. Sci. Technol. A, Volume 4, Issue 6, pp. 3059-3065, 1986), le dip coating ou le dépôt chimique en phase vapeur assisté par décharge plasma avec des paramètres de dépôt qui produisent une forte compétition entre le dépôt et l'attaque de la couche (cf. Dalakos, Plawsky, Persans, MRS Symp. Proc. Vol. 762, 2003 et G. Cicala, G. Bruno, P. Capezzuto, Pure & Appl. Chem., Vol 68, No. 5, pp. 1143-1149, 1996).

Selon une autre variante de l'invention, la morphologie de surface de la face inférieure 11 de la couche intermédiaire 5, telle que définie ci-dessus, peut être obtenue en réalisant, postérieurement au dépôt de ladite couche intermédiaire 5, une étape supplémentaire d'égalisation de la surface de ladite face inférieure 11 de la couche intermédiaire 5 pour obtenir la morphologie de surface de la face inférieure 11 requise. L'étape de dépôt de la couche intermédiaire 5 peut utiliser les procédés classiques de dépôt, tels que évaporation, pulvérisation cathodique, dépôt chimique. On utilise préférentiellement le dépôt chimique en phase vapeur assisté par décharge plasma PECVD.

L'étape supplémentaire d'égalisation de surface utilise l'une des techniques choisies parmi le groupe comprenant le polissage chimico-mécanique (cf. J. Benedict et al., Proc. Mat. Res. Soc. Symp. 254, 1992), l'attaque chimique (par exemple avec du HCI ou du HN03 pour les couches intermédiaires en ZnO ou avec du HF pour les couches intermédiaires à base de silicium), le traitement plasma (cf. WO 2007/113037) et le sablage, connus de l'homme du métier.

La cellule "Micromorph" selon l'invention présente une couche intermédiaire dont les faces présentent des morphologies de surface permettant de concilier de manière optimale les morphologies requises par chacune des faces de la couche intermédiaire, et d'obtenir ainsi un dispositif plus performant.

La présente description est basée sur un dispositif comprenant deux cellules élémentaires. Il est bien évident que le dispositif selon l'invention peut comprendre plus de deux cellules élémentaires, dont au moins deux cellules sont séparées par une couche intermédiaire selon l'invention.

Les exemples suivants illustrent la présente invention sans toutefois en limiter la portée.

### Exemples:

On compare deux cellules tandems de type "Micromorph" avec configuration p-i-n/p-i-n:
- avec une couche intermédiaire standard (Exemple 1), et
- avec une couche intermédiaire selon l'invention (Exemple 2).

Les autres éléments des cellules sont identiques.

Les cellules élémentaires sont composées d'une cellule supérieure 4 en silicium amorphe et d'une cellule inférieure 6 en silicium microcristallin (cf. D. Fischer, S. Dubail, J. A. A. Selvan, N. P. Vaucher, R. Platz, C. Hof, U. Kroll, J. Meier, P. Torres, H. Keppner, N. Wyrsch, M. Goetz, A. Shah, and K.-D. Ufert, in 25 IEEE PVSC, Washington D. C., 1996, p. 1053).

Le substrat 2 utilisé est du verre (Schott AF 45) et la texture à surfaces élémentaires fortement inclinées est donnée par la première couche conductrice 3 en ZnO (contact avant) qui est déposée par dépôt chimique en phase vapeur à basse pression (LPCVD) (cf. S. Fay, J. Steinhauser, N. Oliveira, E. Vallat-Sauvain, C. Ballif, "Opto-electronic properties of rough LP-CVD ZnO:B for use as TCO in thin-film silicon solar cells", Thin Solid Films, 515 (24), p.8558-8561, 2007).

La cellule supérieure 4 a une épaisseur de 300 nm et la cellule inférieure 6 une épaisseur de 3000 nm.

La deuxième couche conductrice 7 (contact arrière) en ZnO est déposée par dépôt chimique en phase vapeur à basse pression (LPCVD) sur lequel est appliqué un diélectrique blanc qui sert de réflecteur arrière. (cf. J. Meier, U. Kroll, J. Spitznagel, S. Benagli, T. Roschek, G. Pfanner, C. Ellert, G. Androutsopoulos, A. Huegli, G. Buechel, A. Buechel, M. Nagel, L. Feitknecht, C. Bucher, « Progress in up-scaling of thin film silicon solar cells by large-area PECVD KAI systems », Proc. of the 31th IEEE Photovoltaic Specialist Conference, Lake Buena Vista, FL, USA, pp. 1464-1467, January, 2005).

La couche intermédiaire de type standard est constituée par une couche de SiOx de 150 nm déposée par PECVD (cf. Buehlmann, Bailat, Domine, Billet, Meillaud, Feltrin, Ballif, APL 91, 143505, 2007).

La couche intermédiaire présentant la morphologie selon l'invention est constituée par une couche de SiOx de 150 nm déposée par PECVD et dont la face inférieure 11 a subi, postérieurement au dépôt, un polissage chimico-mécanique, afin d'égaliser sa surface. Ce polissage chimico-mécanique (CMP) est effectué par un drap (N° article 40500232, DENKA D.200, drap type Nap 5x de Struers) et un abrasif à base de particules de silice colloïdale (N° article 40700001, OPSIF, suspension OP-S 5lt de Struers). Ce procédé permet d'obtenir une couche intermédiaire présentant la morphologie de surface de la face inférieure adapté à la croissance de la cellule inférieure.

Les morphologies de surface des faces supérieure et inférieure de la couche intermédiaire selon l'invention sont mesurées selon la méthode décrite ci-dessus. On obtient l'intégrale de la distribution angulaire des deux faces de la couche intermédiaire en question, représentée sur la figure 3. Dans cette figure, les angles sont représentés en abscisse. En ordonnée est représentée la proportion des surfaces élémentaires présentant une inclinaison égale ou inférieure à un angle donné. La courbe C correspond à la face inférieure de la couche intermédiaire et la courbe D correspond à la face supérieure. Pour chaque surface, il est défini un angle α₉₀ qui indique que 90% des surfaces élémentaires présentent une inclinaison inférieure ou égale à cet angle. Dans le présent exemple, α_{90inf} est égal à 36° et α₉₀ₛᵤₚ est égal à 48°, soit une différence entre α₉₀ₛᵤₚ et α_{90inf} égale à 12°.

A titre de comparaison, les faces supérieure et inférieure de la couche intermédiaire de type standard présentent la même morphologie.

La tension de circuit ouvert (Vco) et le facteur de forme (FF) sont extraits de la courbe caractéristique courant-tension (IV), mesuré sous illumination avec un spectre solaire AM1.5G. Le courant de court-circuit (Jcc) est calculé à partir de la mesure de l'efficacité quantique externe (EQE), en intégrant sur le spectre de 350 à 1100 nm le produit de l'EQE fois le flux de photon incident pour le spectre solaire défini par AM1.5G. Le rendement (η) est calculé en multipliant Vco avec FF et Jcc.

Les résultats obtenus sont indiqués dans le tableau ci-dessous:

| Dispositif | Couche intermédiaire | Jcc (mA/cm2) | Vco (V) | FF | η(%) |
|---|---|---|---|---|---|
| Exemple 1 (comparatif.) | SiO_{×} 150 nm | 12.35 | 1.351 | 0.672 | 11.2 |
| Exemple 2 (Invention) | SiO_{×} 150 nm + polissage | 12.22 | 1.351 | 0.734 | 12.1 |

Les résultats montrent d'une part que la cellule "Micromorph" selon l'invention est fonctionnelle. D'autre part, le bénéfice obtenu en utilisant une couche intermédiaire présentant la morphologie de surface selon l'invention consiste en une augmentation du facteur de forme (FF), se traduisant par une augmentation du rendement de conversion η de 11,2% à 12.1%, soit une amélioration de 8%.

## Revendications

1. Dispositif photoélectrique (1) à jonctions multiples comprenant un substrat (2) sur lequel est déposée une première couche conductrice (3), au moins deux dispositifs photoélectriques élémentaires (4, 6) de configuration p-i-n ou p-n, sur lesquels est déposée une seconde couche conductrice (7), et au moins une couche intermédiaire (5) prévue entre deux dispositifs photoélectriques élémentaires adjacents (4, 6), **caractérisé en ce que** ladite couche intermédiaire (5) présente, du côté de la lumière entrant, une face supérieure (10) et de l'autre côté, une face inférieure (11), les dites faces supérieure (10) et inférieure (11) présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ est l'angle pour lequel 90% des surfaces élémentaires de la face supérieure (10) de la couche intermédiaire (5) présentent une inclinaison inférieure ou égale à cet angle, et α_{90inf} est l'angle pour lequel 90% des surfaces élémentaires de la face inférieure (11) de la couche intermédiaire (5) présentent une inclinaison inférieure ou égale à cet angle.

2. Dispositif selon la revendication 1, **caractérisé en ce que** α₉₀ₛᵤₚ est compris entre 40° et 80°.

3. Dispositif selon la revendication 1 ou 2, **caractérisé en ce que** α_{90inf} est compris entre 0° et 40°.

4. Dispositif selon l'une quelconque des revendications précédentes, **caractérisé en ce que** le dispositif photoélectrique élémentaire (4), situé du coté du substrat (2) par rapport à la couche intermédiaire (5), est à base de silicium amorphe et **en ce que** l'autre dispositif photoélectrique élémentaire (6) est à base de silicium microcristallin.

5. Dispositif selon l'une quelconque des revendications précédentes, **caractérisé en ce que** la couche intermédiaire (5) présente une épaisseur comprise entre 10 nm et 500 nm, de préférence entre 50 nm et 150 nm.

6. Dispositif selon l'une quelconque des revendications précédentes, **caractérisé en ce que** la couche intermédiaire (5) est constituée d'une couche d'un matériau choisi parmi le groupe comprenant l'oxyde de zinc, des oxydes de silicium dopés, des oxydes de silicium poreux dopés, l'oxyde d'étain, l'oxyde d'indium, le carbure de silicium dopé, le silicium amorphe dopé, le silicium microcristallin dopé, ainsi que leurs combinaisons.

7. Dispositif selon l'une quelconque des revendications précédentes, **caractérisé en ce que** la morphologie de surface de la face inférieure (11) de la couche intermédiaire (5) est obtenue en utilisant un procédé de dépôt de la couche intermédiaire permettant d'obtenir, lors de son dépôt, une surface aplanie correspondant à la morphologie de surface de la face inférieure (11) requise.

8. Dispositif selon l'une quelconque des revendications 1 à 6, **caractérisé en ce que** la morphologie de surface de la face inférieure (11) de la couche intermédiaire (5) est obtenue en réalisant, postérieurement au dépôt de ladite couche intermédiaire (5), une égalisation de la surface de ladite face inférieure (11) pour obtenir la morphologie de surface de la face inférieure (11) requise.

9. Procédé de réalisation d'un dispositif photoélectrique (1) à jonctions multiples comprenant un substrat (2) sur lequel est déposée une première couche conductrice (3), au moins deux dispositifs photoélectriques élémentaires (4, 6) de configuration p-i-n ou p-n, sur lesquels est déposée une seconde couche conductrice (7), **caractérisé en ce qu'**il comprend une étape de dépôt, sur au moins l'un desdits dispositifs photoélectriques élémentaires (4), d'une couche intermédiaire (5) présentant, du côté de la lumière entrant, une face supérieure (10) et de l'autre côté, une face inférieure (11), les dites faces supérieure (10) et inférieure (11) présentant respectivement une morphologie de surface comprenant des surfaces élémentaires inclinées telle que la différence entre α₉₀ₛᵤₚ et α_{90inf} est supérieure ou égale à 3°, préférentiellement supérieure ou égale à 6°, plus préférentiellement supérieure ou égale à 10°, et encore plus préférentiellement supérieure ou égale à 15°; où α₉₀ₛᵤₚ est l'angle pour lequel 90% des surfaces élémentaires de la face supérieure (10) de la couche intermédiaire (5) présentent une inclinaison inférieure ou égale à cet angle, et α_{90inf} est l'angle pour lequel 90% des surfaces élémentaires de la face inférieure (11) de la couche intermédiaire (5) présentent une inclinaison inférieure ou égale à cet angle.

10. Procédé selon la revendication 9, **caractérisé en ce que** la couche intermédiaire (5) est constituée d'une couche d'un matériau choisi parmi le groupe comprenant l'oxyde de zinc, des oxydes de silicium dopés, des oxydes de silicium poreux dopés, l'oxyde d'étain, l'oxyde d'indium, le carbure de silicium dopé, le silicium amorphe dopé, le silicium microcristallin dopé, ainsi que leurs combinaisons.

11. Procédé selon l'une quelconque des revendications 9 et 10, **caractérisé en ce que**, lors de l'étape de dépôt de la couche intermédiaire (5), on utilise un procédé de dépôt permettant d'obtenir, lors de son dépôt, une surface aplanie correspondant à la morphologie de surface de la face inférieure (11) requise.

12. Procédé selon l'une quelconque des revendications 9 et 10, **caractérisé en ce qu'**il comprend, après l'étape de dépôt de la couche intermédiaire (5), une étape supplémentaire d'égalisation de surface de la face inférieure (11) de la couche intermédiaire (5) de manière à obtenir la morphologie de surface de la face inférieure (11) requise.

13. Procédé selon la revendication 12, **caractérisé en ce que** ladite étape supplémentaire d'égalisation de surface de la face inférieure (11) utilise l'une des techniques choisies parmi le groupe comprenant le polissage chimico-mécanique, l'attaque chimique, le traitement plasma et le sablage.
